# EUROPEAN PATENT APPLICATION

(11) **EP 4 742 051 A1**
(43) Date of publication of application: **13.05.2026**
(21) Application number: 24844237.8
(22) Date of filing: 11.03.2024
(51) Int. Cl.: G06F 13/42

(54) **MEMORY MODULE, ELECTRONIC DEVICE AND SIGNAL TRANSMISSION METHOD**

(30) Priority: 27.07.2023 CN 202310937615
(71) Applicant: Huawei Technologies Co., Ltd., Shenzhen, Guangdong 518129 (CN)
(72) Inventor: WANG, Luo, Shenzhen, Guangdong 518129 (CN); LUO, Fei, Shenzhen, Guangdong 518129 (CN); WANG, Guoyu, Shenzhen, Guangdong 518129 (CN)
(74) Representative: Isarpatent
(86) International application number: PCT/CN2024/080947
(87) International publication number: WO 2025/020540

(57) **Abstract**

A memory module, an electronic device, and a signal transmission method are provided. The memory module is a dual in-line memory module. A foolproof bayonet and a locking bayonet are disposed on a circuit board of the memory module, and a plurality of memory chips are separately disposed on board surfaces on two sides of the circuit board. The plurality of memory chips are connected to a processing chip through a parallel bus, and the processing chip is connected to a gold finger interface through a serial bus. Through this arrangement, the memory module can implement a serial interconnection relationship by using a connector, so that a data transmission rate can be reliably improved, crosstalk and simultaneous switching noise that are generated because high-speed transmission is performed based on the parallel bus can be avoided, and SI can be effectively improved. The memory module actually occupies a small board area, which is conducive to a high-density layout. In general, this provides technical assurance for a high-density layout and high-performance running of an architecture. In addition, the memory module occupies roughly same physical space as a conventional memory module, which is conducive to a standardized design of a structure of a mainboard.

## Description

This application claims priority to Chinese Patent Application No. 202310937615.6, filed with the China National Intellectual Property Administration on July 27, 2023 and entitled "MEMORY MODULE, ELECTRONIC DEVICE, AND SIGNAL TRANSMISSION METHOD", which is incorporated herein by reference in its entirety.

### TECHNICAL FIELD

Embodiments of this application relate to the field of computer hardware, and in particular, to a memory module, an electronic device, and a signal transmission method.

### BACKGROUND

A dual in-line memory module (dual in-line memory module, DIMM) connector is used in a double data rate (double data rate, DDR) parallel bus system. The DIMM connector is installed and connected to a memory module, to implement connection between a central processing unit (central processing unit, CPU) and a synchronous dynamic random access memory (synchronous dynamic random access memory, SDRAM) chip configured on the memory module. Through this connection, an efficient and low-cost memory system is formed between the CPU and a storage medium, to implement a fast read/write access operation.

With development of data-intensive application such as high-performance computing and artificial intelligence, requirements for bandwidth and a capacity of the memory system continuously increase, and this prompts continuous improvement in a DDR parallel bus rate and an SDRAM chip capacity on the memory module. Currently, a DDR parallel bus has gradually transitioned from a DDR fourth generation (DDR4) to a DDR fifth generation (DDR5), and a single-line rate has also increased from 2.133 Gbps-3.2 Gbps to 4.8 Gbps-8.4 Gbps. Due to problems such as crosstalk and simultaneous switching noise (Simultaneous Switching Noise, SSN), further improving the single-line rate will affect signal integrity (SI).

To resolve problems of the bandwidth and the capacity of the memory system, a serial memory solution is proposed in the industry to implement memory expansion. A memory expansion module and a mainboard may be connected in different manners. A typical manner is using a GENZ (Generation Z, which is a high-speed protocol) connector for vertical insertion. A height size of the GENZ connector is large, and is limited by internal space of a device. Consequently, a board surface width of the memory expansion module cannot meet a layout requirement of a large-size expansion chip. Another typical manner is using a GENZ straddle mount connector for horizontal insertion. The memory expansion module is arranged in parallel with the mainboard, and occupies large space on a board surface of the mainboard, which is not conducive to high-density implementation of an architecture.

### SUMMARY

Embodiments of this application provide a memory module, an electronic device, and a signal transmission method, to provide technical assurance for improving SI and considering a design requirement of a high-density layout of an architecture while effectively improving a signal transmission rate.

A first aspect of embodiments of this application provides a memory module. The memory module includes a circuit board, a processing chip and a plurality of memory chips disposed on the circuit board, and a gold finger interface located at an edge of the circuit board. A foolproof bayonet and a locking bayonet are disposed on the circuit board, and a plurality of memory chips are separately disposed on board surfaces on two sides of the circuit board. The plurality of memory chips are connected to the processing chip through a parallel bus, and the processing chip is connected to the gold finger interface through a serial bus. Through this arrangement, the memory module can implement a serial interconnection relationship by using a connector. A data transmission rate can be reliably improved by using the serial bus, and crosstalk and simultaneous switching noise that are generated because high-speed transmission is performed based on the parallel bus can be avoided to some extent, so that reliability and stability requirements of signal transmission are met, and SI is effectively improved. In addition, based on a small height size of a DIMM connector, for same assembly space, the circuit board provided in this solution has a large board surface width, so that a layout of a large component can be implemented. In addition, the memory module is in a vertical insertion manner, and actually occupies a small board area. In general, this provides technical assurance for a high-density layout and high-performance running of an architecture.

In addition, physical space occupied by the memory module in an electronic device is roughly the same as physical space occupied by a conventional memory module, which is conducive to a standardized design of a structure of a mainboard of the electronic device, and can further improve structural adaptability between the memory module and the mainboard.

For example, the memory module may be a memory expansion card, and the processing chip is a memory expansion chip configured to manage and control several memory chips, to ensure compatibility and collaboration between the memory module and a computer system. For example, the computer system may determine a data storage position based on access frequency, for example, may store data with high access frequency in storage space provided by a system memory module, and store data with low access frequency in storage space provided by the memory chip of the memory expansion card, to improve performance and a processing capability of the computer system.

Based on the first aspect, embodiments of this application further provide a first implementation of the first aspect: The gold finger interface includes a first power supply pin region, a second power supply pin region, a management and control signal pin region, and a serial bus pin region that are separately disposed on board surfaces on two sides of the circuit board. The first power supply pin region is configured to provide a first voltage power supply, the second power supply pin region is configured to provide a second voltage power supply, and a voltage of the second voltage power supply is lower than a voltage of the first voltage power supply. Each of the board surfaces on the two sides of the circuit board includes two serial bus pin regions. In an arrangement direction of the gold finger interface, the first power supply pin region is located at one end of the circuit board, one of the two serial bus pin regions is arranged adjacent to the first power supply pin region, the other of the two serial bus pin regions is located at the other end of the circuit board, and the management and control signal pin region and the second power supply pin region are located between the two serial bus pin regions. In this way, electromagnetic crosstalk that may be caused, to another pin region, by the first power supply pin region that outputs a high voltage can be reduced. In addition, the management and control signal pin region and the second power supply pin region may be flexibly arranged between the two serial bus pin regions according to a requirement, to provide a part of power and a control signal channel for a component on the circuit board, which has good adaptability.

For example, the power supply provided by the first power supply pin region has a 5 V, 6 V, or 12 V voltage, and is converted into a low-voltage power supply (which for example, has a 1.2 V or 1 V voltage) by using a secondary power supply on the circuit board, to supply power to components such as the processing chip and the memory chip on the circuit board.

During actual application, in an application scenario in which a large quantity of components are arranged on the circuit board and overall load is large, the second power supply pin region may provide a part of power based on an actual running status.

Based on the first implementation of the first aspect, embodiments of this application further provide a second implementation of the first aspect: a blank pin is disposed between the first power supply pin region and the adjacently arranged serial bus pin region. The "blank pin" herein is a pin for which no signal is defined. Based on disposition of the blank pin, interference of noise in the first power supply pin region to a differential signal can be effectively prevented.

For example, one or more blank pins may be alternatively disposed. During actual application, proper configuration can be performed when impact of 12 V noise is effectively prevented.

Based on the first implementation of the first aspect or the second implementation of the first aspect, embodiments of this application further provide a third implementation of the first aspect: The gold finger interface further includes a differential clock pin, to ensure data synchronization in high-speed serial transmission. The differential clock pin is located between the blank pin and the serial bus pin region arranged adjacent to the first power supply pin region.

Based on the first implementation of the first aspect, or the second implementation of the first aspect, or the third implementation of the first aspect, embodiments of this application further provide a fourth implementation of the first aspect: Parts that are of the gold finger interface and that are located on a board surface on one side of the circuit board are gold fingers on a first surface, and parts that are of the gold finger interface and that are located on a board surface on the other side of the circuit board are gold fingers on a second surface, the serial bus pin region includes differential pair pins that are spaced apart, the differential pair pin includes two differential signal pins configured to transmit a differential signal, and a ground pin is disposed between two adjacent differential pair pins. In this way, crosstalk that may be generated between the adjacent differential pairs can be avoided.

Based on the fourth implementation of the first aspect, embodiments of this application further provide a fifth implementation of the first aspect: The serial bus pin region includes eight differential pair pins that are spaced apart, and differential pair pins of the gold fingers on the first surface and differential pair pins of the gold fingers on the second surface are staggered. In other words, two eight-lane serial signal pins are disposed on gold fingers on each surface from the gold fingers on the first surface and the gold fingers on the second surface, and based on this, X16 high-speed transmission bandwidth may be provided.

Based on the fourth implementation of the first aspect or the fifth implementation of the first aspect, embodiments of this application further provide a sixth implementation of the first aspect: Four ground pins are disposed between adjacent differential pair pins, and in the arrangement direction of the gold finger interface, four ground pins on gold fingers on one surface from the gold fingers on the first surface and the gold fingers on the second surface are consecutively arranged by using one differential pair pin on gold fingers on the other surface from the gold fingers on the first surface and the gold fingers on the second surface as a center. The four GND pins that are spaced apart have a good anti-interference capability when a single-line rate is further evolved and improved. In addition, signal crosstalk between the differential pair pins on the two surfaces can be further properly controlled on a basis of reducing signal crosstalk between two adjacent differential pair pins on a current surface.

Based on the sixth implementation of the first aspect, embodiments of this application further provide a seventh implementation of the first aspect: Four ground pins on one side of the gold fingers on the first surface are connected through a first conductor sheet, four ground pins on one side of the gold fingers on the second surface are connected through a second conductor sheet, the first conductor sheet is electrically connected to four third pads, the second conductor sheet is electrically connected to four fourth pads, the third pads on the one side of the gold fingers on the first surface are in a one-to-one correspondence with the fourth pads on the one side of the gold fingers on the second surface, and the third pad and the fourth pad that correspond to each other on the two sides are formed through one via. In this way, forming through the via is implemented based on disposition of the first conductor sheet and the second conductor sheet and a POFV process, and all ground pins are connected to same ground, which helps maintain consistency and stability of high-speed signal transmission, and can further effectively suppress noise and interference.

Based on the fourth implementation of the first aspect or the fifth implementation of the first aspect, embodiments of this application further provide an eighth implementation of the first aspect: Two ground pins are disposed between adjacent differential pair pins, a differential pair pin on one side of the gold fingers on the first surface is arranged in correspondence with two ground pins on one side of the gold fingers on the second surface, and a differential pair pin on the one side of the gold fingers on the second surface is arranged in correspondence with two ground pins on the one side of the gold fingers on the first surface. In this way, differential signals in the serial bus pin region are defined to be compact, and a quantity of pins configured to define the management and control signal pin region and the second power supply (low-voltage power supply) pin region is large.

During actual application, the two ground pins on the one side of the gold fingers on the first surface are connected through a first conductor sheet, the two ground pins on the one side of the gold fingers on the second surface are connected through a second conductor sheet, the first conductor sheet is electrically connected to three third pads, the second conductor sheet is electrically connected to three fourth pads, two third pads located on two edge sides and electrically connected to the first conductor sheet are in a one-to-one correspondence with fourth pads located on two edge sides and electrically connected to the second conductor sheet, and the third pad and the fourth pad that correspond to each other on the two sides are formed through one via. Similarly, ground pins on the two sides of the gold fingers on the first surface and the gold fingers on the second surface are connected to same ground, which helps maintain consistency and stability of high-speed signal transmission, and further effectively suppresses noise and interference.

Based on the fourth implementation of the first aspect or the fifth implementation of the first aspect, embodiments of this application further provide a ninth implementation of the first aspect: One ground pin is disposed between adjacent differential pair pins.

During actual application, a ground pin on one side of the gold fingers on the first surface is connected to a first conductor sheet, the first conductor sheet is electrically connected to two third pads, a ground pin on one side of the gold fingers on the second surface is connected to a second conductor sheet, the second conductor sheet is electrically connected to two fourth pads, the third pads on the one side of the gold fingers on the first surface are in a one-to-one correspondence with the fourth pads on the one side of the gold fingers on the second surface, and the third pad and the fourth pad that correspond to each other on the two sides are formed through one via. Through this arrangement, ground pins on the two sides of the gold fingers on the first surface and the gold fingers on the second surface are connected to same ground, which helps maintain consistency and stability of high-speed signal transmission, and further effectively suppresses noise and interference.

A second aspect of embodiments of this application provides an electronic device. The electronic device includes a housing and a mainboard and a memory module that are disposed in the housing. A DIMM connector is disposed on the mainboard. The memory module is inserted into the DIMM connector on the mainboard, and the memory module is the foregoing memory module.

During actual application, the electronic device may be a server, a computer, or a high-performance computing cluster. In addition, the electronic device may alternatively be a switch, a router, or the like.

A third aspect of embodiments of this application provides a signal transmission method. The signal transmission method is applied to a memory module. Specially, the memory module is a dual in-line memory module, and includes a circuit board, a processing chip and a plurality of memory chips disposed on the circuit board, and a gold finger interface located at an edge of the circuit board. A foolproof bayonet and a locking bayonet are disposed on the circuit board. The plurality of memory chips are connected to the processing chip through a parallel bus, and the processing chip is connected to the gold finger interface through a serial bus. The signal transmission method includes the following step: transmitting a data signal, a control signal, and a power supply signal through the gold finger interface of the memory module.

Based on the third aspect, embodiments of this application further provide a first implementation of the third aspect: The gold finger interface includes a first power supply pin region, a second power supply pin region, a serial bus pin region, and a management and control signal pin region that are separately disposed on board surfaces on two sides of the circuit board. The first power supply pin region is configured to provide a first voltage power supply, the second power supply pin region is configured to provide a second voltage power supply, and a voltage of the second voltage power supply is lower than a voltage of the first voltage power supply. Each of the board surfaces on the two sides of the circuit board includes two serial bus pin regions. In an arrangement direction of the gold finger interface, the first power supply pin region is located at one end of the circuit board, one of the two serial bus pin regions is arranged adjacent to the first power supply pin region, the other of the two serial bus pin regions is located at the other end of the circuit board, and the management and control signal pin region and the second power supply pin region are located between the two serial bus pin regions. In addition, transmitting the data signal, the control signal, and the power supply signal through the gold finger interface includes: transmitting the data signal by using the serial bus pin region, transmitting the control signal by using the management and control signal pin region, transmitting a first power supply signal in the power supply signal by using the first power supply pin region, and transmitting a second power supply signal in the power supply signal by using the second power supply pin region.

### BRIEF DESCRIPTION OF DRAWINGS

FIG. 1 is a diagram of a structure of an electronic device according to an embodiment of this application;
FIG. 2 is a diagram of a structure of a memory module according to an embodiment of this application;
FIG. 3 is a diagram of arrangement of a gold finger interface of a memory module according to an embodiment of this application;
FIG. 4 is a locally enlarged diagram of a serial bus pin region of the gold finger interface shown in FIG. 3;
FIG. 5 is a diagram of a position relationship between pins on two sides of a serial bus pin region shown in FIG. 3 and pads;
FIG. 6 is a diagram of arrangement of a gold finger interface of another memory module according to an embodiment of this application;
FIG. 7 is a locally enlarged diagram of a serial bus pin region of the gold finger interface shown in FIG. 6;
FIG. 8 is a diagram of a position relationship between pins on two sides of a serial bus pin region shown in FIG. 6 and pads;
FIG. 9 is a diagram of arrangement of a gold finger interface of still another memory module according to an embodiment of this application;
FIG. 10 is a locally enlarged diagram of a serial bus pin region of the gold finger interface shown in FIG. 9; and
FIG. 11 is a diagram of a position relationship between pins on two sides of a serial bus pin region shown in FIG. 9 and pads.

### DESCRIPTION OF EMBODIMENTS

Embodiments of this application provide a memory module, so that technical assurance can be provided, on a basis of obtaining a higher data transmission rate, for improving a high-density layout of an architecture.

For ease of description, terms in this application are first explained as follows.

DIMM connector: The DIMM connector is a connector configured to install and connect to a memory module, and uses a parallel high-speed transmission technology to provide a memory capacity and performance that are required by a system. The DIMM connector may support different standard protocols. The DIMM connector is, for example, a 288-pin (PIN) connector that may support a DDR4 SDRAM (double data rate fourth generation synchronous dynamic random access memory) standard protocol or a DDR5 SDRAM (double data rate fifth generation synchronous dynamic random access memory) standard protocol, but this is not limited thereto.

Memory expansion module (Memory Expansion Module): The memory expansion module is a hardware device configured to increase a memory capacity of a computer system. The memory expansion module is usually a plug-in card module, and may provide an additional physical memory to expand an available memory capacity of the system.

Memory expansion chip (Memory Expansion Chip): The memory expansion chip is an integrated circuit processing chip configured to expand a memory capacity of a computer system. The memory expansion chip is usually a chip integrated in a memory expansion module or another expansion device, and is responsible for managing and controlling an additional physical memory, to ensure compatibility and collaboration between the memory expansion module or the another expansion device and the computer system. The memory expansion chip that implements memory expansion based on a serial memory solution transmits data and a control signal through a serial bus, ensuring a higher data transmission rate.

For connection between a memory expansion card and a mainboard, a typical manner is using a GENZ connector for vertical insertion. A height size of the GENZ connector is large, and is limited by internal space of a device. Consequently, a board surface width of the memory expansion module cannot meet a layout requirement of a large-size expansion chip. Another typical manner is using a GENZ straddle mount connector for horizontal insertion. The memory expansion module is arranged in parallel with the mainboard, and occupies large space on a board surface of the mainboard, which is not conducive to high-density implementation of an architecture.

In view of this, embodiments of this application provide a memory module. The memory module includes a circuit board and a processing chip and a plurality of memory chips disposed on the circuit board. An edge of the circuit board has a gold finger interface that adapts to a DIMM connector. A foolproof bayonet and a locking bayonet are disposed on the circuit board, and a plurality of memory chips are separately disposed on board surfaces on two sides of the circuit board. The plurality of memory chips are connected to the processing chip through a parallel bus, and the processing chip is connected to the gold finger interface through a serial bus. The "gold finger layout" herein means that an electrical connection between a gold finger and a pin on a side of the DIMM connector can be implemented, and may include positions of gold fingers and a spacing between gold fingers, and further include sizes of the gold fingers, a quantity of the gold fingers, and the like.

Through this arrangement, the memory module can implement a serial interconnection relationship by using the connector. A data transmission rate can be reliably improved by using the serial bus, and crosstalk and simultaneous switching noise that are generated because high-speed transmission is performed based on the parallel bus can be avoided to some extent, so that reliability and stability requirements of signal transmission can be met, and SI is effectively improved. In addition, based on a small height size of the DIMM connector, for same assembly space, the circuit board provided in this solution has a large board surface width, so that a layout of a large quantity of large components can be implemented. In addition, the memory module is in a vertical insertion manner, and actually occupies a small board area. In general, this provides technical assurance for a high-density layout and high-performance running of an architecture.

In addition, physical space occupied by the memory module in an electronic device is roughly the same as physical space occupied by a conventional memory module, which is conducive to a standardized design of a structure of a mainboard of the electronic device, and can further improve structural adaptability between the memory module and the mainboard.

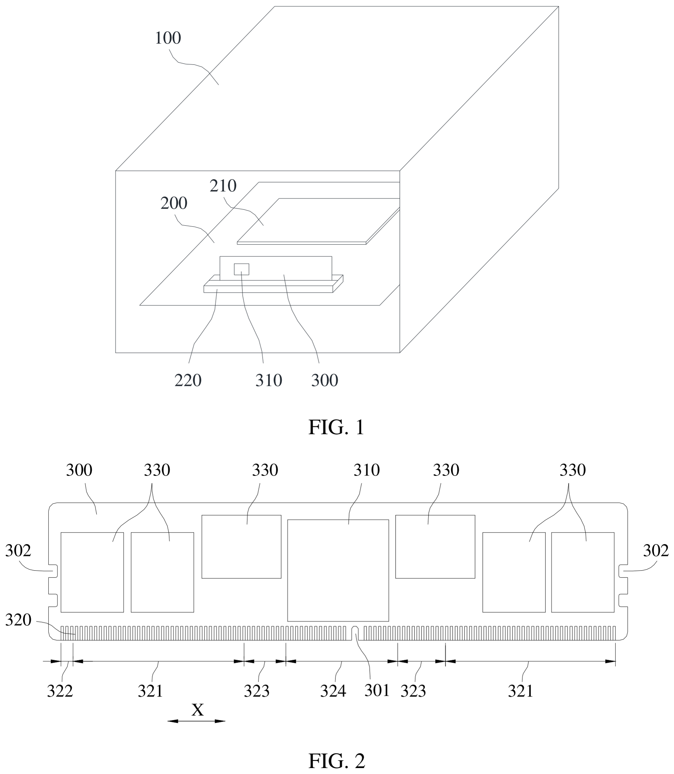

FIG. 1 is a diagram of a structure of an electronic device according to an embodiment of this application. A memory module 300 may be used in the electronic device shown in FIG. 1. In a specific implementation, the electronic device may be a server, a computer, or a high-performance computing cluster. For a data center server with high power, high integration, and an ultra-large scale, the foregoing technical advantages are particularly clear. In addition, the electronic device may alternatively be a switch, a router, or the like. This is not limited in embodiments of this application.

As shown in FIG. 1, the electronic device includes a housing 100 and a mainboard 200 and a memory module 300 that are disposed in the housing 100. A CPU 210 is disposed on the mainboard 200, and a DIMM connector 220 is disposed on the mainboard 200. A processing chip 310 is disposed on a circuit board of the memory module 300. A gold finger interface (not shown in the figure) at an edge of the bottom of the circuit board is inserted into the DIMM connector 220 on the mainboard 200, that is, vertically inserted into the DIMM connector 220 relative to a board surface of the mainboard 200, so that the memory module 300 is electrically connected to the mainboard 200 to implement signal transmission.

FIG. 2 is a diagram of a structure of a memory module according to an embodiment of this application. A processing chip 310 located on a circuit board of the memory module 300 and a gold finger interface 320 are connected based on a serial protocol standard, and the gold finger interface 320 and a DIMM connector 220 are also connected based on the serial protocol standard.

A foolproof bayonet 301 and a locking bayonet 302 that adapt to the DIMM connector 220 may be disposed on a board-shaped body of the memory module 300, and a foolproof structure and a lock-up fastener structure (not shown in the figure) on a side of the DIMM connector 220 are fully used to implement assembly and fastening of the memory module 300. In other words, an assembly structure based on the DIMM connector 220 can meet requirements of assembly reliability and stability of the memory module 300 and provide technical assurance for serial high-speed transmission performance without a need to increase design implementation costs.

In a specific implementation, the memory module 300 may be a memory expansion card, and the processing chip 310 is correspondingly a memory expansion chip. Each memory chip 330 is connected to the processing chip 310 through a parallel bus, so that the memory chip is managed and controlled by using the processing chip 310. Herein, in FIG. 2, six memory chips 330 are used as an example for illustration, and a specific quantity of disposed memory chips 330 may be determined according to an overall design of the memory expansion card.

In another specific implementation, the memory module 300 may alternatively be any memory module that needs to be configured with a high-speed transmission interface, such as an artificial intelligence training card, an artificial intelligence inference card, or a graphics processing operation card. This is not limited in embodiments of this application.

It may be understood that, for the gold finger interface 320 of the memory module 300, a size of a gold finger and a configuration spacing between gold fingers are set in correspondence with a slot pin of the DIMM connector 220. Herein, a quantity of gold fingers disposed at an edge of the bottom of the memory module 300 may be determined according to an actual performance requirement of the memory module. A DIMM connector 220 having 288 pins is used as an example. 288 gold fingers may be disposed on the circuit board and are all enabled; or 288 gold fingers may be disposed on the circuit board and are partially enabled according to the performance requirement.

Certainly, a quantity of gold fingers may alternatively be set according to an actual enabling requirement, for example, but is not limited to 210 gold fingers, 260 gold fingers, or the like, provided that serial interconnection can be established through disposition of corresponding gold fingers. This is not limited in embodiments of this application.

As shown in FIG. 2, the gold finger interface 320 at the edge of the bottom of the circuit board of the memory module 300 includes a serial bus pin region 321, a first power supply pin region 322, a management and control signal pin region 323, and a second power supply pin region 324 that are separately and correspondingly disposed on board surfaces on two sides of the edge of the circuit board. For ease of description, parts that are of the gold finger interface 320 and that are located on a board surface on one side of the circuit board are defined as gold fingers on a first surface, and parts that are of the gold finger interface 320 and that are located on a board surface on the other side of the circuit board are defined as gold fingers on a second surface.

The serial bus pin region 321 is configured to transmit a high-speed interconnection signal, for example, but is not limited to transmitting a data signal, to implement data storage and reading. In a specific implementation, the serial bus pin region 321 may transmit a plurality of groups of high-speed interconnection signals. The management and control signal pin region 323 is configured to transmit a low-speed signal, for example, but is not limited to transmitting an I2C signal, an enable signal, a GPIO signal, or the like.

The first power supply pin region 322 provides a first voltage power supply for transmitting a first power supply signal. The first voltage power supply has, for example, a 12 V voltage, but this is not limited thereto. The first voltage power supply is converted into a low-voltage power supply (for example, with a 1.2 V or 1 V voltage) by using a secondary power supply on the memory module 300, to supply power to components such as the memory expansion chip and the memory chip on the memory module 300. The second power supply pin region 324 provides a second voltage power supply for transmitting a second power supply signal. The second voltage power supply has, for example, a 1.2 V, 3.3 V, or 5 V voltage, but this is not limited thereto, to supply power to components such as the memory expansion chip and the memory chip on the memory module 300.

It may be understood that, in a case in which a large quantity of components are arranged on the memory module 300, overall load is large, and a power supply capability of the first power supply pin region 322 cannot meet working requirements of all the components, the second power supply pin region 324 may supply a part of power based on an actual running state. In a specific implementation, power management and control may be performed by using the memory expansion chip and a power circuit of the memory module, which is not described herein again.

Herein, in a case in which the power supply capability of the first power supply pin region 322 satisfies a working requirement of each component on the memory module 300, the second power supply pin region 324 may serve as power supply redundancy to ensure reliable and stable running of the memory module.

As shown in FIG. 2, in an arrangement direction X of the gold finger interface 320, the first power supply pin region 322 is located at one end of the circuit board. That is, a 12 V pin is disposed at an edge side position of the circuit board. In this way, electromagnetic crosstalk that may be caused, to another pin region, by the first power supply pin region 322 that outputs a high voltage can be reduced.

In this implementation solution, the gold finger interface 320 includes two serial bus pin regions 321. In the arrangement direction X of the gold finger interface 320, one of the two serial bus pin regions 321 is arranged adjacent to the first power supply pin region 322, and the other of the two serial bus pin regions 321 is located at the other end of the circuit board. The management and control signal pin region 323 and the second power supply pin region 324 are centrally arranged between the two serial bus pin regions 321, to avoid crosstalk to a pin in the serial bus pin region 321. In correspondence with a form of the slot pin of the DIMM connector 220, the management and control signal pin region 323 and the second power supply pin region 324 are roughly located in a long pin region of the circuit board, and the first power supply pin region 322 and the serial bus pin region 321 are correspondingly located in a short pin region.

In another specific implementation, a quantity of disposed serial bus pin regions 321 may be determined based on a high-speed transmission performance requirement of the memory module.

On a basis of properly controlling crosstalk between pins, a region layout of each pin region further needs to consider a component arrangement relationship on a board surface of the memory module 300. For example, for the memory expansion card, when the memory expansion chip is arranged in the middle of the circuit board, and the memory chips are respectively arranged on two sides of the memory expansion chip, the management and control signal pin region 323 and the second power supply pin region 324 may be arranged between the two serial bus pin regions 321, to optimize an internal line of the circuit board. Further, the gold finger interface 320 further includes a differential clock pin, which may be specifically arranged adjacent to one of the two serial bus pin regions 321.

For the management and control signal pin region 323 and the second power supply pin region 324, two management and control signal pin regions 323 may be included. As shown in FIG. 2, the two management and control signal pin regions 323 are respectively disposed on two sides of the second power supply pin region 324. In another specific implementation, a plurality of second power supply pin regions 324 may be included, and each second power supply pin region 324 separately configures a different power supply voltage. In addition, in the arrangement direction of the gold finger interface, the two management and control signal pin regions 323 may be arranged between the second power supply pin regions 324 in a staggered manner.

It may be understood that, for the management and control signal pin region 323 and the second power supply pin region 324 that are disposed between the two serial bus pin regions 321, the corresponding second power supply pin region 324 and the corresponding management and control signal pin region 323 may be defined based on a magnitude of a voltage of the low-voltage power supply and a quantity of low-speed signals, to separately provide a part of power and a control signal channel of the memory module for a component on the circuit board. A specific arrangement manner may be flexibly arranged based on an overall product design. This is not limited in embodiments of this application.

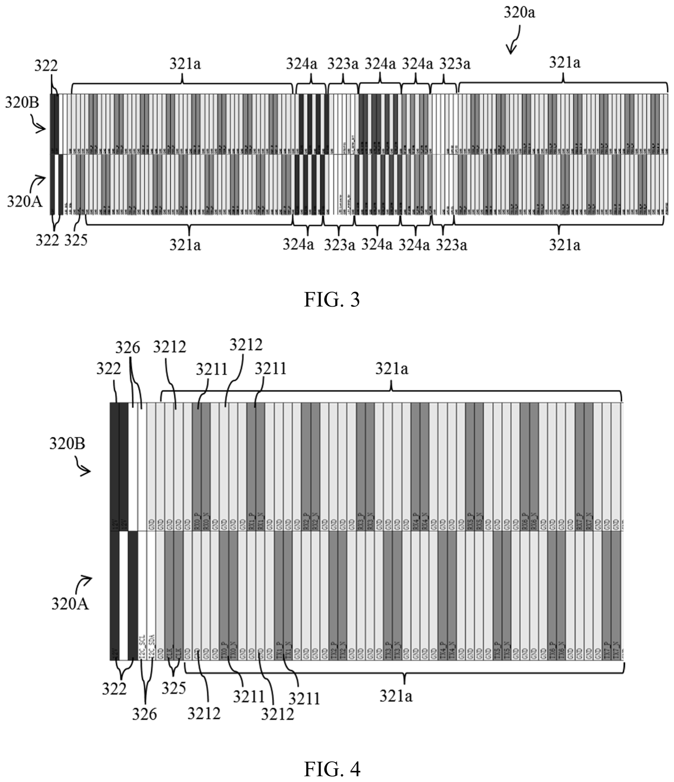

To better understand the technical solutions and technical effects of this application without loss of generality, the following describes specific embodiments in detail with reference to the accompanying drawings. FIG. 3 is a diagram of arrangement of a gold finger interface 320a of a memory module according to an embodiment of this application. As shown in the figure, 144 pins of gold fingers 320A on a first surface and 144 pins of gold fingers 320B on a second surface are separately sequentially arranged on board surfaces of a circuit board on a current side, and pins on a surface T and pins on a surface B are disposed in a one-to-one correspondence.

In this implementation solution, gold fingers on each surface from the gold fingers 320A on the first surface and the gold fingers 320B on the second surface includes a first power supply pin region 322 with a power supply voltage of 12 V, two serial bus pin regions 321a, two management and control signal pin regions 323a, and three second power supply pin regions 324a.

Pins on a left end of a current surface are defined as the first power supply pin region 322 for 12 V power supply, which is in a same position as pins for 12 V power supply of a standard DDR5 memory module. A pin region adjacent to the first power supply pin region 322 is defined as one serial bus pin region 321a. That is, the serial bus pin region 321a is arranged adjacent to the first power supply pin region 322. A pin region on a right end of the current surface is defined as the other serial bus pin region 321a. Pin regions between the two serial bus pin regions 321a are defined as two management and control signal pin regions 323a and three second power supply pin regions 324a that are in the following sequence: a 1^{st} second power supply pin region 324a, a 1^{st} management and control signal pin region 323a, a 2^{nd} second power supply pin region 324a, a 3^{rd} second power supply pin region 324a, and a 2^{nd} management and control signal pin region 323a.

In a specific implementation, the three second power supply pin regions 324a may provide different power supply voltages, for example, but are not limited to providing power supply voltages of 1.2 V, 3.3 V, or 5 V respectively, to meet function requirements of different components on the memory module.

Two eight-lane (lane) serial signal pins are disposed on gold fingers on each surface from the gold fingers 320A on the first surface and the gold fingers 320B on the second surface, and X16 high-speed transmission bandwidth may be provided. The serial bus pin region 321a includes eight differential pair pins, two differential signal pins form a differential pair pin configured to transmit a differential signal, and four ground (GND) pins are defined between adjacent differential pair pins. FIG. 4 shows an arrangement relationship of the serial bus pin region 321a of the gold finger interface 320a shown in FIG. 3. The serial bus pin region 321a shown in the figure is a serial bus pin region located at a left end of FIG. 3, and a pin arrangement relationship is clearly illustrated in a partial enlargement manner. It may be understood that pin arrangement manners of the two serial bus pin regions 321a are the same. Therefore, the serial bus pin region located at the right end of FIG. 3 is not enlarged for illustration.

In this implementation solution, in the serial bus pin regions 321a of the gold fingers 320A on the first surface and the gold fingers 320B on the second surface, four GND pins 3212 are spaced apart between two adjacent differential pair pins 3211, to reduce signal crosstalk in a high-speed serial transmission process. The four GND pins that are spaced apart have a good anti-interference capability when a single-pair rate is further evolved and improved.

With reference to FIG. 4, differential pair pins 3211 of the gold fingers 320A on the first surface and differential pair pins 3211 of the gold fingers 320B on the second surface are staggered Specifically, in an arrangement direction of the gold finger interface, four GND pins 3212 on gold fingers on one surface from the gold fingers 320A on the first surface and the gold fingers 320B on the second surface are consecutively arranged by using one differential pair pin 3211 on gold fingers on the other surface from the gold fingers 320A on the first surface and the gold fingers 320B on the second surface as a center. In other words, two pins of a differential pair pin 3211 on a board surface on one side are arranged in correspondence with central two of four GND pins 3212 that are consecutively arranged on a board surface on the other side. In this way, signal crosstalk between the differential pair pins on the two surfaces can be further properly controlled on a basis of reducing signal crosstalk between two adjacent differential pair pins 3211 on a current surface.

In another specific implementation, it is not limited to that four GND pins 3212 on one of the serial bus pin region 321a of the gold fingers 320A on the first surface and the serial bus pin region 321a on the gold fingers 320B on the second surface are consecutively arranged by using one differential pair pin 3211 on the other of the serial bus pin region 321a of the gold fingers 320A on the first surface and the serial bus pin region 321a on the gold fingers 320B on the second surface as a center. For example, two pins of a differential pair pin 3211 on a board surface on one side are arranged in correspondence with two GND pins on an edge side (left side or right side) of four GND pins 3212 on a board surface on the other side, but this is not limited thereto. In this way, signal crosstalk between the differential pair pins on the two surfaces can also be reduced.

Further, as shown in FIG. 3 and FIG. 4, the gold finger interface 320a of the memory module described in this implementation solution includes one differential clock pin 325. The differential clock pin 325 is located between a serial bus pin region 321a on a left side of the gold fingers 320A on the first surface and the 12 V first power supply pin region 322. Certainly, the differential clock pin 325 may alternatively be configured at a position adjacent to another serial bus pin region 321a, including a position adjacent to any serial bus pin region 321a of the gold fingers 320B on the second surface. This is not limited in embodiments of this application.

Optionally, to further reduce noise interference of the first power supply pin region 322, two blank pins 326 are disposed between the first power supply pin region 322 and the differential clock pin 325 of the gold fingers 320A on the first surface. The "blank pin" herein is a pin for which no signal is defined. Two blank pins 326 are also disposed between the first power supply pin region 322 and the serial bus pin region 321a of the gold fingers 320B on the second surface. Based on disposition of the blank pin, interference of 12 V noise to a differential signal can be effectively prevented.

In another specific implementation, one or more blank pins 326 may be disposed. It should be understood that an excessive quantity of blank pins affects definition of a quantity of available pins. Comparatively, two blank pins are disposed between a 12 V power supply pin and a differential signal, so that the quantity of available pins can be properly configured when impact that may be caused by 12 V noise is effectively prevented.

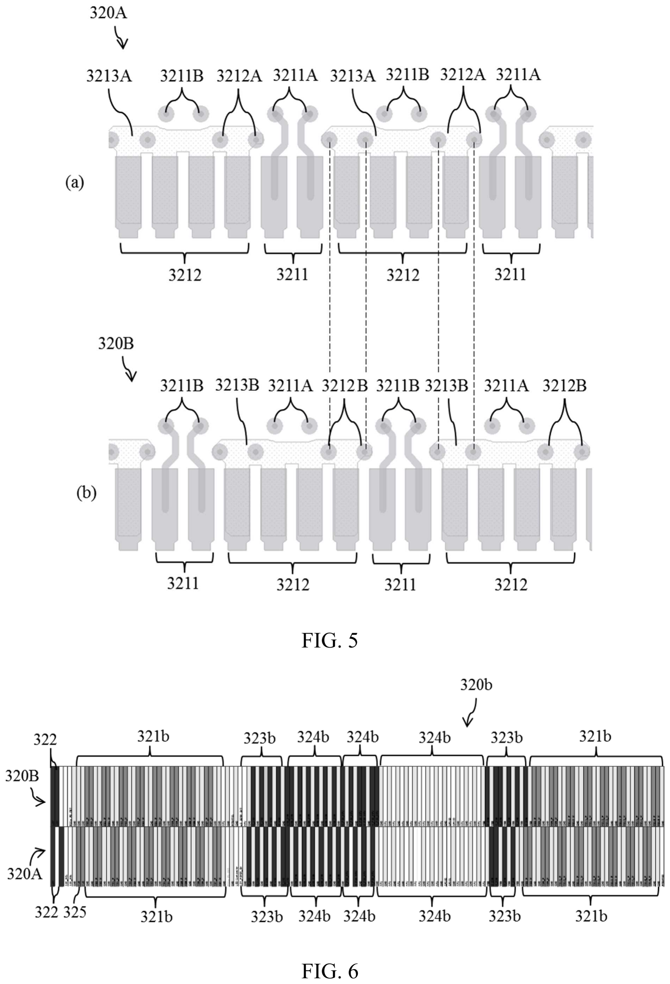

Optionally, to support a signal transmission rate under this serial standard protocol, in a specific implementation, electrical connection between each pin of the gold finger interface and a corresponding conductor layer in the circuit board may be implemented by using a POFV (plated over filled via, plated over filled via) process. The POFV process is a special via filling process for a VIP (Vias In Pad, Vias In Pad), in which a material such as resin is filled into a via, and then a pad is formed through copper deposition and plating, so that PCB layout density and electrical performance can be improved. FIG. 5 is a diagram of a position relationship between pins on two sides of the serial bus pin region shown in FIG. 3 and pads. (a) in FIG. 5 shows a position relationship between pins of the gold fingers 320A on the first surface and pads, and (b) in FIG. 5 shows a position relationship between pins of the gold fingers 320B on the second surface and pads.

In the arrangement direction of the gold finger interface, a first pad 3211A electrically connected to the differential pair pin 3211 on one side of the gold fingers 320A on the first surface and a second pad 3211B electrically connected to the differential pair pin 3211 on one side of the gold fingers 320B on the second surface are spaced apart, and separately implement corresponding electrical connection (not shown in the figure) by using a conductor in the circuit board. In addition, in an extension direction of the gold fingers, the first pad 3211A and the second pad 3211B of the differential pair pins 3211 are disposed in a staggered manner with a pad of the GND pin 3212. Specifically, compared with the pads electrically connected to the GND pin 3212, the first pad 3211A and the second pad 3211B are disposed on the circuit board away from the gold finger.

As shown in (a) in FIG. 5, four GND pins 3212 between two differential pair pins 3211 on the one side of the gold fingers 320A on the first surface are connected through a first conductor sheet 3213A, to obtain a same ground level. As shown in (b) in FIG. 5, four GND pins 3212 between two differential pair pins 3211 on the one side of the gold fingers 320B on the second surface are connected through a second conductor sheet 3213B, to obtain the same ground level. In this way, the ground pins are connected to same ground, which can help maintain consistency and stability of high-speed signal transmission, and can further effectively suppress noise and interference.

Further, the first conductor sheet 3213A on the one side of the gold fingers 320A on the first surface is electrically connected to four third pads 3212A, and the second conductor sheet 3213B on the one side of the gold fingers 320B on the second surface is electrically connected to four fourth pads 3212B. The third pads 3212A and the fourth pads 3212B are spaced apart in the arrangement direction of the gold finger interface. In addition, as a correspondence between pads shown by dashed lines in FIG. 5, the third pads 3212A on the one side of the gold fingers 320A on the first surface are in a one-to-one correspondence with the fourth pads 3212B on the one side of the gold fingers 320B on the second surface, and the third pad 3212A and the fourth pad 3212B that correspond to each other on the two sides are formed through one via. In this case, GND pins on the board surfaces on the two sides have the same ground level.

In the implementation solution described in FIG. 3, four ground pins are defined between two adjacent differential pair pins in the serial bus pin region. In another specific implementation, another quantity of ground pins may alternatively be defined according to an overall design requirement. For example, two ground pins or one ground pin is defined between two adjacent differential pair pins, but this is not limited thereto.

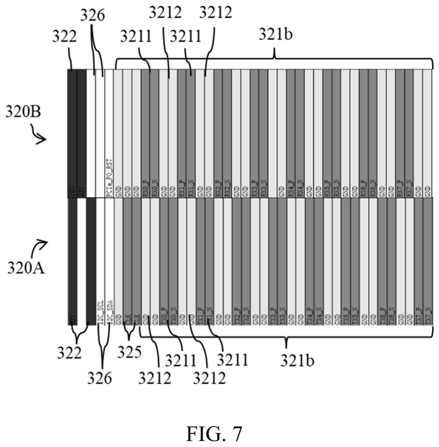

FIG. 6 is a diagram of arrangement of a gold finger interface of another memory module according to an embodiment of this application, and FIG. 7 is a locally enlarged diagram of a serial bus pin region of the gold finger interface shown in FIG. 6. To clearly show differences and relationships between this implementation solution and the gold finger interface arrangement solution described in FIG. 3, compositions or structures of a same function are illustrated by using a same mark in the figure.

In the gold finger interface 320b provided in this implementation solution, gold fingers on each surface from gold fingers 320A on a first surface and gold fingers 320B on a second surface includes a first power supply pin region 322 with a power supply voltage of 12 V, two serial bus pin regions 321b, two management and control signal pin regions 323b, and three second power supply pin regions 324b. In an overall layout, as shown in FIG. 6, the two management and control signal pin regions 323b and the three second power supply pin regions 324b are also defined between the two serial bus pin regions 321b and are in the following sequence: a 1^{st} management and control signal pin region 323b, a 1^{st} second power supply pin region 324b, a 2^{nd} second power supply pin region 324b, a 3^{rd} second power supply pin region 324b, and a 2^{nd} management and control signal pin region 323b. One of the two serial bus pin regions 321b is defined in a pin region adjacent to the first power supply pin region 322, and the other of the two serial bus pin regions 321b is defined in a pin region at a right end.

Two ground (GND) pins are defined between adjacent differential pair pins in the serial bus pin region 321b. Refer to FIG. 7 together. There are two consecutively arranged GND pins 3212 between two adjacent differential pair pins 3211 of gold fingers on each surface from the gold fingers 320A on the first surface and the gold fingers 320B on the second surface, and differential pair pins 3211 of the gold fingers 320A on the first surface and differential pair pins 3211 of the gold fingers 320B on the second surface are staggered. In other words, a pin that is on a side of the gold fingers 320B on the second surface and that corresponds to the differential pair pin 3211 on a side of the gold fingers 320A on the first surface is defined as the GND pin 3212, and a pin that is on the side of the gold fingers 320B on the second surface and that corresponds to the GND pin 3212 on the side of the gold fingers 320A on the first surface is defined as the differential pair pin 3211, so that signal crosstalk between the differential pair pins on the two surfaces can be reduced. This implementation solution is different from the implementation solution described in FIG. 3 in that differential signals in the serial bus pin region 321b are defined to be compact, and a quantity of pins configured to define the management and control signal pin region 323b and the second power supply (low-voltage power supply) pin region 324b is large.

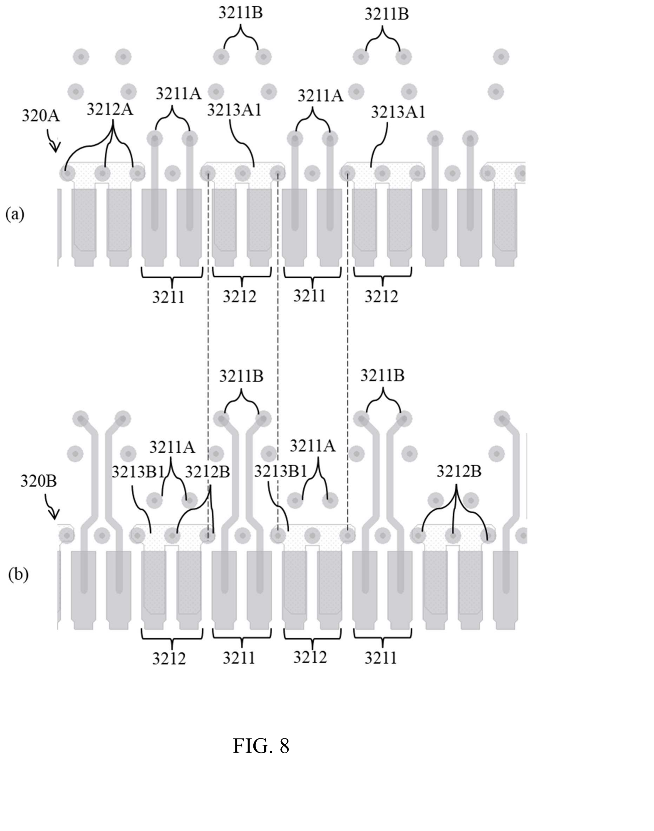

FIG. 8 is a diagram of a position relationship between pins on two sides of the serial bus pin region shown in FIG. 6 and pads. (a) in FIG. 8 shows a position relationship between pins of the gold fingers 320A on the first surface and pads, and (b) in FIG. 8 shows a position relationship between pins of the gold fingers 320B on the second surface and pads.

On a board surface of a circuit board, a first pad 3211A electrically connected to the differential pair pin 3211 on one side of the gold fingers 320A on the first surface and a second pad 3211B electrically connected to the differential pair pin 3211 on one side of the gold fingers 320B on the second surface are staggered, and separately implement corresponding electrical connection (not shown in the figure) by using a conductor in the circuit board. Similarly, the first pad 3211A and the second pad 3211B of the differential pair pins 3211 are disposed in a staggered manner with a pad of the GND pin 3212.

As shown in (a) in FIG. 8, two GND pins 3212 between two differential pair pins 3211 on the one side of the gold fingers 320A on the first surface are connected through a first conductor sheet 3213A1, to obtain a same ground level. As shown in (b) in FIG. 8, two GND pins 3212 between two differential pair pins 3211 on the one side of the gold fingers 320B on the second surface are connected through a second conductor sheet 3213B1, to obtain the same ground level.

Further, the first conductor sheet 3213A1 on the one side of the gold fingers 320A on the first surface is electrically connected to three third pads 3212A, and the second conductor sheet 3213B1 on the one side of the gold fingers 320B on the second surface is electrically connected to three fourth pads 3212B. The third pads 3212A and the fourth pads 3212B are spaced apart in an arrangement direction of the gold finger interface. As a correspondence between pads shown by dashed lines in FIG. 8, two third pads 3212A that are on two edge sides and that are electrically connected to the first conductor sheet 3213A1 are in a one-to-one correspondence with two fourth pads 3212B1 that are on two edge sides and that are electrically connected to the second conductor sheet 3213B1, and the third pad 3212A and the fourth pad 3212B that correspond to each other on the two sides are formed through one via. In addition, GND pins on board surfaces on the two sides have a same ground level, which helps maintain consistency and stability of high-speed signal transmission, and effectively suppresses noise and interference.

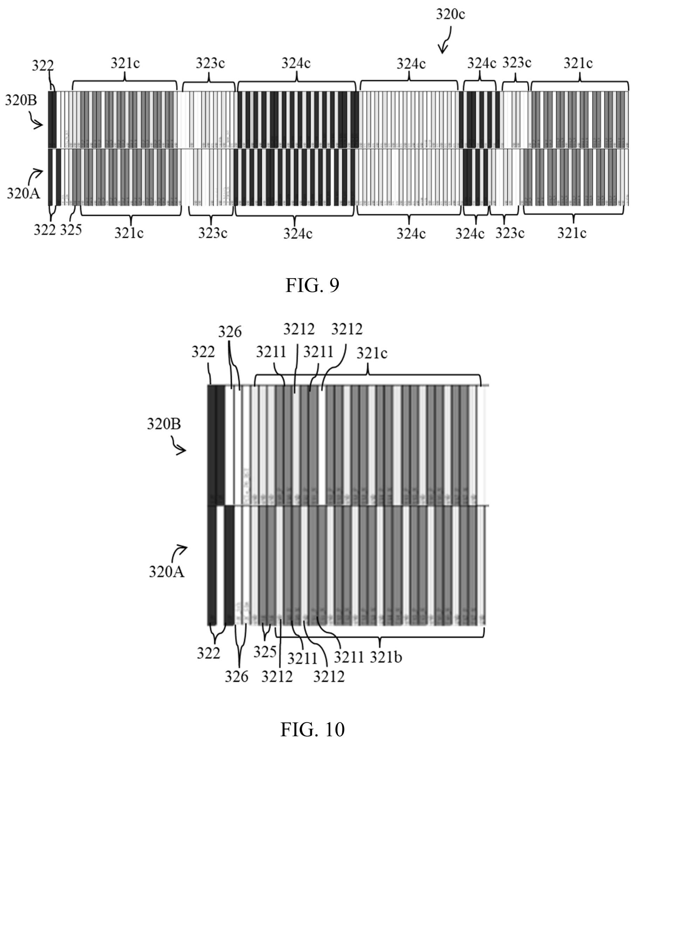

FIG. 9 is a diagram of arrangement of a gold finger interface of still another memory module according to an embodiment of this application, and FIG. 10 is a locally enlarged diagram of a serial bus pin region of the gold finger interface shown in FIG. 9. To clearly show differences and relationships between this implementation solution and the gold finger interface arrangement solutions described in FIG. 3 and FIG. 6, compositions or structures of a same function are illustrated by using a same mark in the figure.

In the gold finger interface 320c provided in this implementation solution, gold fingers on each surface from gold fingers 320A on a first surface and gold fingers 320B on a second surface includes a first power supply pin region 322 with a power supply voltage of 12 V, two serial bus pin regions 321c, two management and control signal pin regions 323c, and three second power supply pin regions 324c. In an overall layout, as shown in FIG. 9, the two management and control signal pin regions 323c and the three second power supply pin regions 324c are defined between the two serial bus pin regions 321c and are in the following sequence: a 1st management and control signal pin region 323c, a 1st second power supply pin region 324c, a 2nd second power supply pin region 324c, a 3rd second power supply pin region 324c, and a 2nd management and control signal pin region 323c. One of the two serial bus pin regions 321c is defined in a pin region adjacent to the first power supply pin region 322, and the other of the two serial bus pin regions 321c is defined in a pin region at a right end.

One ground (GND) pin is defined between adjacent differential pair pins in the serial bus pin region 321c. Refer to FIG. 10 together. There is one GND pin 3212 between two adjacent differential pair pins 3211 of gold fingers on each surface from the gold fingers 320A on the first surface and the gold fingers 320B on the second surface, and differential pair pins 3211 of the gold fingers 320A on the first surface and differential pair pins 3211 of the gold fingers 320B on the second surface are staggered. In other words, a pin that is on a side of the gold fingers 320B on the second surface and that corresponds to the differential pair pin 3211 on a side of the gold fingers 320A on the first surface is defined as one of the GND pin 3212 and the differential pair pin 3211, and a pin that is on the side of the gold fingers 320B on the second surface and that corresponds to the GND pin 3212 on the side of the gold fingers 320A on the first surface is defined as the other one of the differential pair pin 3211. This implementation solution is different from the implementation solutions described in FIG. 3 and FIG. 6 in that differential signals in the serial bus pin region 321b are defined to be the most compact, and a quantity of pins configured to define a low-voltage power supply and a low-speed signal is more abundant, so that a corresponding layout can be implemented according to requirements of different application scenarios.

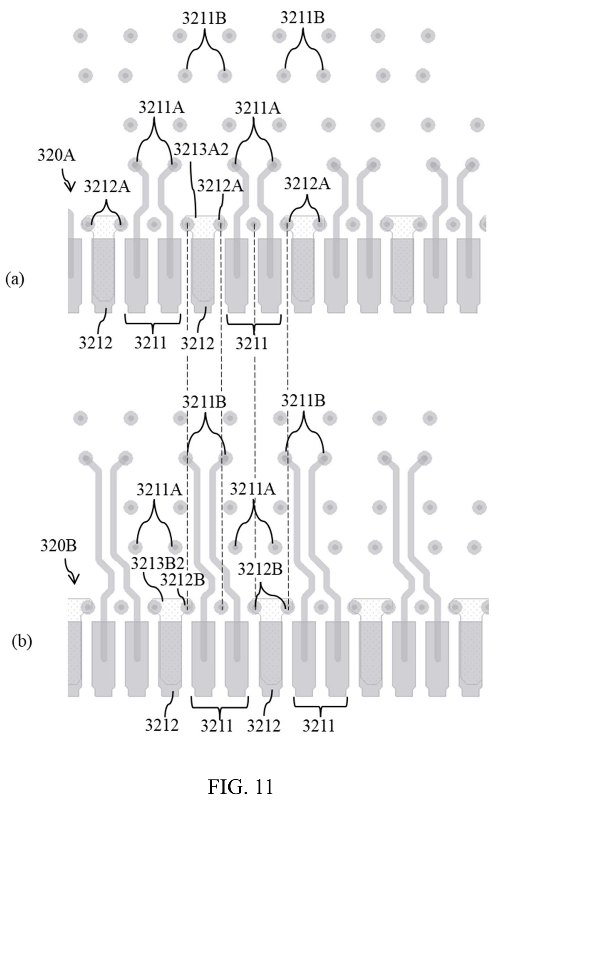

FIG. 11 is a diagram of a position relationship between pins on two sides of the serial bus pin region shown in FIG. 9 and pads. (a) in FIG. 9 shows a position relationship between pins of the gold fingers 320A on the first surface and pads, and (b) in FIG. 9 shows a position relationship between pins of the gold fingers 320B on the second surface and pads.

On a board surface of a circuit board, a first pad 3211A electrically connected to the differential pair pin 3211 on one side of the gold fingers 320A on the first surface and a second pad 3211B electrically connected to the differential pair pin 3211 on one side of the gold fingers 320B on the second surface are staggered, and separately implement corresponding electrical connection (not shown in the figure) by using a conductor in the circuit board. Similarly, the first pad 3211A and the second pad 3211B of the differential pair pins 3211 are disposed in a staggered manner with a pad of the GND pin 3212.

As shown in (a) in FIG. 11, the GND pin 3212 on the one side of the gold fingers 320A on the first surface is connected to a first conductor sheet 3213A1, and the first conductor sheet 3213A2 is electrically connected to two third pads 3212A. As shown in (b) in FIG. 11, the GND pin 3212 on the one side of the gold fingers 320B on the second surface is connected to a second conductor sheet 3213B1, and the second conductor sheet 3213B2 is electrically connected to two fourth pads 3212B. The third pads 3212A and the fourth pads 3212B are spaced apart in an arrangement direction of the gold finger interface. As a correspondence between pads shown by dashed lines in FIG. 11, the two third pads 3212A electrically connected to the first conductor sheet 3213A2 are in a one-to-one correspondence with the two fourth pads 3212B1 electrically connected to the second conductor sheet 3213B1, and the third pad 3212A and the fourth pad 3212B that correspond to each other on the two sides are formed through one via, so that the GND pins on board surfaces on the two sides have a same ground level. In other words, the ground pins are connected to same ground, which helps maintain consistency and stability of high-speed signal transmission, and effectively suppresses noise and interference.

Based on the gold finger interface definition manners described in the foregoing embodiments, selection may be performed according to actual requirements of different application scenarios. For example, when a serial transmission rate needs to be increased to 16 Gbps or higher, the memory module in the gold finger interface definition manner described in FIG. 3 may be selected, to meet a function requirement for improvement in a single-pair rate based on a good anti-crosstalk capability. For another example, when a mainboard is required to provide more low-speed signals and low-voltage power supply channels, the memory module in the gold finger interface definition manner described in FIG. 9 may be selected, to implement a corresponding layout based on a more abundant quantity of pins for the low-voltage power supplies and low-speed signal pins.

In a specific implementation, a memory expansion card is used as an example. The memory expansion card is installed on a DIMM connector on the mainboard, and a system may identify and use additional memory provided by a memory chip on the memory expansion card, to provide more available memory capacities for an operating system and an application to use. Using the memory expansion card provided in embodiments of this application can effectively improve performance and a processing capability of a computer system. For example, the computer system may determine a data storage position based on access frequency, for example, may store data with high access frequency in storage space provided by a system memory module, and store data with low access frequency in storage space provided by the memory chip of the memory expansion card. In particular, this technical advantage is especially significant when it is necessary to process a large data set, run a memory-intensive application, or perform a complex computing task.

It should be noted that the foregoing memory module uses the DIMM connector for physical connection and high-speed electrical connection, and may be further used in another scenario in which serial signal transmission needs to be implemented based on the DIMM connector. The another scenario is, for example, an existing computing or storage product but is not limited thereto, and further includes a future computing or storage product. This is not limited in embodiments of this application.

Based on the foregoing memory module, an embodiment of this application further provides a signal transmission method. The method includes the following step:
transmitting a data signal, a control signal, and a power supply signal through a gold finger interface.

Optionally, transmitting the data signal, the control signal, and the power supply signal through the gold finger interface includes: transmitting the data signal by using a serial bus pin region, transmitting the control signal by using a management and control signal pin region, and transmitting a first power supply signal in the power supply signal by using a first power supply pin region.

Further, optionally, transmitting the data signal, the control signal, and the power supply signal through the gold finger interface includes: transmitting a second power supply signal in the power supply signal by using a second power supply pin region.

It should be noted that, the orientation words "bottom", "left end", "right end", and the like used in this specification are defined by using a status of the memory module shown in the figure as a reference for description, and a memory module that is assembled and used in an actual scenario is not limited to the status shown in the figure. For example, in a use state, a mainboard of an electronic device extends vertically, or an extension direction of the mainboard of the electronic device is at a specific included angle with a vertical direction. It should be understood that use of the foregoing orientation word does not constitute a substantive limitation on the memory module described in this application.

In addition, ordinal numbers "first", "second", "third", and "fourth" used in this specification are merely used to describe compositions or structures of same functions in the technical solutions. It may be understood that use of the foregoing ordinal number does not constitute an understanding limitation on the technical solution claimed in this application.

The foregoing descriptions are merely example implementations of the present invention. It should be noted that a person of ordinary skill in the art may make several improvements or polishing without departing from the principle of the present invention and the improvements or polishing shall fall within the protection scope of the present invention.

## Claims

1. A memory module, wherein the memory module is a dual in-line memory module, comprising:
a circuit board, wherein a foolproof bayonet and a locking bayonet are disposed on the circuit board;
a processing chip and a plurality of memory chips disposed on the circuit board; and
a gold finger interface located at an edge of the circuit board, wherein
the plurality of memory chips are connected to the processing chip through a parallel bus, and the processing chip is connected to the gold finger interface through a serial bus.

2. The memory module according to claim 1, wherein the gold finger interface comprises a first power supply pin region, a second power supply pin region, a management and control signal pin region, and a serial bus pin region that are separately disposed on board surfaces on two sides of the circuit board, the first power supply pin region is configured to provide a first voltage power supply, the second power supply pin region is configured to provide a second voltage power supply, and a voltage of the second voltage power supply is lower than a voltage of the first voltage power supply; and
each of the board surfaces on the two sides of the circuit board comprises two serial bus pin regions; and in an arrangement direction of the gold finger interface, the first power supply pin region is located at one end of the circuit board, one of the two serial bus pin regions is arranged adjacent to the first power supply pin region, the other of the two serial bus pin regions is located at the other end of the circuit board, and the management and control signal pin region and the second power supply pin region are located between the two serial bus pin regions.

3. The memory module according to claim 2, wherein a blank pin is disposed between the first power supply pin region and the adjacently arranged serial bus pin region.

4. The memory module according to claim 3, wherein the gold finger interface further comprises a differential clock pin, and the differential clock pin is located between the blank pin and the serial bus pin region arranged adjacent to the first power supply pin region.

5. The memory module according to any one of claims 2 to 4, wherein the serial bus pin region comprises differential pair pins that are spaced apart, the differential pair pin comprises two differential signal pins configured to transmit a differential signal, a ground pin is disposed between two adjacent differential pair pins, parts that are of the gold finger interface and that are located on a board surface on one side of the circuit board are gold fingers on a first surface, and parts that are of the gold finger interface and that are located on a board surface on the other side of the circuit board are gold fingers on a second surface.

6. The memory module according to claim 5, wherein the serial bus pin region comprises eight differential pair pins that are spaced apart, and differential pair pins of the gold fingers on the first surface and differential pair pins of the gold fingers on the second surface are staggered.

7. The memory module according to claim 6, wherein four ground pins are disposed between adjacent differential pair pins, and in the arrangement direction of the gold finger interface, four ground pins on gold fingers on one surface from the gold fingers on the first surface and the gold fingers on the second surface are consecutively arranged by using one differential pair pin on gold fingers on the other surface from the gold fingers on the first surface and the gold fingers on the second surface as a center.

8. The memory module according to claim 7, wherein four ground pins on one side of the gold fingers on the first surface are connected through a first conductor sheet, t four ground pins on one side of the gold fingers on the second surface are connected through a second conductor sheet, the first conductor sheet is electrically connected to four third pads, the second conductor sheet is electrically connected to four fourth pads, the third pads on the one side of the gold fingers on the first surface are in a one-to-one correspondence with the fourth pads on the one side of the gold fingers on the second surface, and the third pad and the fourth pad that correspond to each other on the two sides are formed through one via.

9. The memory module according to claim 6, wherein two ground pins are disposed between adjacent differential pair pins, a differential pair pin on one side of the gold fingers on the first surface is arranged in correspondence with two ground pins on one side of the gold fingers on the second surface, and the differential pair pin on the one side of the gold fingers on the second surface is arranged in correspondence with two ground pins on the one side of the gold fingers on the first surface.

10. The memory module according to claim 9, wherein the two ground pins on the one side of the gold fingers on the first surface are connected through a first conductor sheet, the two ground pins on the one side of the gold fingers on the second surface are connected through a second conductor sheet, the first conductor sheet is electrically connected to three third pads, the second conductor sheet is electrically connected to three fourth pads, two third pads located on two edge sides and electrically connected to the first conductor sheet are in a one-to-one correspondence with fourth pads located on two edge sides and electrically connected to the second conductor sheet, and the third pad and the fourth pad that correspond to each other on the two sides are formed through one via.

11. The memory module according to claim 6, wherein one ground pin is disposed between adjacent differential pair pins.

12. The memory module according to claim 11, wherein the ground pin on one side of the gold fingers on the first surface is connected to a first conductor sheet, the first conductor sheet is electrically connected to two third pads, the ground pin on one side of the gold fingers on the second surface is connected to a second conductor sheet, the second conductor sheet is electrically connected to two fourth pads, the third pads on the one side of the gold fingers on the first surface are in a one-to-one correspondence with the fourth pads on the one side of the gold fingers on the second surface, and the third pad and the fourth pad that correspond to each other on the two sides are formed through one via.

13. The memory module according to any one of claims 1 to 12, wherein the memory module is a memory expansion card, several memory chips are disposed on the circuit board, and the processing chip is a memory expansion chip configured to manage and control the several memory chips.

14. An electronic device, comprising a housing and a mainboard and a memory module that are disposed in the housing, wherein a DIMM connector is disposed on the mainboard, the memory module is inserted into the DIMM connector on the mainboard, and the memory module is the memory module according to any one of claims 1 to 13.

15. A signal transmission method, wherein the signal transmission method is applied to a memory module, the memory module is a dual in-line memory module, the memory module comprises a circuit board, a processing chip, a plurality of memory chips, and a gold finger interface, a foolproof bayonet and a locking bayonet are disposed on the circuit board, the processing chip and the plurality of memory chips are disposed on the circuit board, the gold finger interface is located at an edge of the circuit board, the plurality of memory chips are connected to the processing chip through a parallel bus, and the processing chip is connected to the gold finger interface through a serial bus; and the method comprises the following step:
transmitting a data signal, a control signal, and a power supply signal through the gold finger interface.

16. The signal transmission method according to claim 15, wherein the gold finger interface comprises a first power supply pin region, a second power supply pin region, a serial bus pin region, and a management and control signal pin region that are separately disposed on board surfaces on two sides of the circuit board, the first power supply pin region is configured to provide a first voltage power supply, the second power supply pin region is configured to provide a second voltage power supply, and a voltage of the second voltage power supply is lower than a voltage of the first voltage power supply; each of the board surfaces on the two sides of the circuit board comprises two serial bus pin regions; and in an arrangement direction of the gold finger interface, the first power supply pin region is located at one end of the circuit board, one of the two serial bus pin regions is arranged adjacent to the first power supply pin region, the other of the two serial bus pin regions is located at the other end of the circuit board, and the management and control signal pin region and the second power supply pin region are located between the two serial bus pin regions; and
transmitting the data signal, the control signal, and the power supply signal through the gold finger interface comprises:
transmitting the data signal by using the serial bus pin region, transmitting the control signal by using the management and control signal pin region, transmitting a first power supply signal in the power supply signal by using the first power supply pin region, and transmitting a second power supply signal in the power supply signal by using the second power supply pin region.
